# EUROPEAN PATENT APPLICATION

(11) **EP 4 685 430 A1**
(43) Date of publication of application: **28.01.2026**
(21) Application number: 25189361.6
(22) Date of filing: 14.07.2025
(51) Int. Cl.: F41G 1/30, G02B 23/10, H10K 50/813

(54) **OPTICAL SIGHTING DEVICE WITH VARIABLE AIMING POINT**

(30) Priority: 26.07.2024 CN 202411017529
(71) Applicant: Taizhou Guanyu Technology Co., Ltd., Taizhou City, Zhejiang Province (CN)
(72) Inventor: HU, Gengshuo, Taizhou, Zhejiang Province (CN); HSU, Kuo-Cheng, Taichung City 406, Taiwan (TW); TU, Tianbao, Yichang City, Hubei Province (CN)
(74) Representative: Michalski Hüttermann & Partner Patentanwälte mbB

(57) **Abstract**

An optical sighting device is provided. The optical sighting device includes: a transmissive screen disposed at a first end of the optical sighting device, the transmissive screen comprising a concave surface; and a display device disposed at a second end of the optical sighting device, the display device configured to project a first pattern alone or project the first pattern and a second pattern together on the transmissive screen. The first pattern and the second pattern have different shapes; and the first pattern has a geometric center, and the second pattern surrounds the first pattern radially outward from the geometric center.

## Description

### TECHNICAL FIELD

The disclosure relates to an optical sighting device. More particularly, the disclosure relates to an optical sighting device comprising a variable aiming point.

### BACKGROUND

Conventional sighting devices (e.g., gun scopes) use optical components (e.g., lens assemblies) to present an aiming pattern superimposed at the center of the field of view. Conventional sighting devices have center aiming points with fixed sizes, and the sizes of the aiming point affect shooting accuracy (measured in minutes of angle, MOA). Conventional sighting devices cannot change the center aiming point sizes according to different application scenarios, requiring users to purchase various target sighting devices with different aiming point sizes, which causes inconvenience in use and increases unnecessary expenses. Therefore, the optical sighting device industry is seeking solutions to the above issues.

### SUMMARY

An optical sighting device comprises: a transmissive screen disposed at a first end of the optical sighting device, the transmissive screen comprising a concave surface; and a display device disposed at a second end of the optical sighting device, the display device configured to project a first pattern alone or project the first pattern and a second pattern together on the transmissive screen. The first pattern and the second pattern have different shapes; and the first pattern has a geometric center, and the second pattern surrounds the first pattern radially outward from the geometric center.

### BRIEF DESCRIPTION OF THE DRAWINGS

FIG. 1A shows an optical sighting device according to certain implementations of the disclosure.
FIG. 1B shows a perspective view of the optical sighting device according to certain implementations of the disclosure.
FIGS. 2A, 2B, and 2C show reticle patterns according to certain implementations of the disclosure.
FIGS. 3A, 3B, and 3C show central aiming points of reticle patterns according to certain implementations of the disclosure.
FIG. 4 shows a cross-sectional structure of a display device according to certain implementations of the disclosure.
FIG. 5A shows a first conductive layer according to certain implementations of the disclosure.
FIG. 5B shows a relationship between the first conductive layer and a light shielding layer in a top view according to certain implementations of the disclosure.
FIG. 6A shows the first conductive layer according to certain implementations of the disclosure.
FIG. 6B shows a cross-sectional structure of the display device according to certain implementations of the disclosure along line OA shown in FIG. 6A.
FIG. 6C shows a cross-sectional structure of the display device according to certain implementations of the disclosure along line OB shown in FIG. 6A.
FIG. 6D shows a cross-sectional structure of the display device according to certain implementations of the disclosure along line OB shown in FIG. 6A.
FIGS. 7A, 7B, 7C, and 7D show first conductive layers according to certain implementations of the disclosure.

### DETAILED DESCRIPTION

Various embodiments or examples are provided in the following content for implementing different features of the present application. Specific examples of components and arrangements are described below to simplify the disclosure of the present application. Of course, these examples are provided for illustrative purposes only and are not intended to limit the present application. For example, a description referring to a first feature being formed on or above a second feature may include embodiments in which the first and second features are in direct contact, as well as embodiments in which one or more intervening features are formed between the first and second features such that the first and second features are not in direct contact. In addition, the same reference numerals and/or letters may be used repeatedly in different embodiments of the application. Such repetition is for the purpose of simplification and clarity and does not dictate relationships between different embodiments and/or configurations being discussed.

Furthermore, spatially relative terms, such as "beneath", "below", "lower", "above", "higher", and the like, may be used herein for ease of description to describe a relationship between one element or feature and another element or feature as illustrated in drawings. The spatially relative terms are intended to encompass different orientations of a device in use or operation in addition to the orientation depicted in the drawings. The device may be otherwise oriented (rotated 90 degrees or at other orientations) and the spatially relative descriptors used herein may likewise be interpreted accordingly.

While numerical ranges and parameters set forth in broad scopes of the disclosure are approximations, the numerical values presented in specific embodiments are as precise as reasonably possible. However, any numerical value inherently includes certain errors caused by standard deviation from individual tests or measurements. Furthermore, as used herein, the term "about" generally refers to within 10%, 5%, 1%, or 0.5% of a given value or range. Alternatively, the term "about" refers to a value within an acceptable standard deviation of an average value as considered by one skilled in the art. Except in operating/working examples, or unless specifically indicated otherwise, all numerical ranges, amounts, values, and ratios disclosed herein, such as amounts of materials, time periods, temperatures, operating conditions, ratios of amounts, and the like, should be understood as being modified by the term "about" in all instances. Therefore, unless stated otherwise, the numerical parameters set forth in the disclosure and the claims are approximations that may vary as needed. Each numerical parameter should be interpreted at least according to the number of significant digits being presented and by applying ordinary rounding techniques. As used herein, ranges may be expressed as from one endpoint to another endpoint, or between two endpoints. Unless specifically specified otherwise, all ranges disclosed herein include the endpoints.

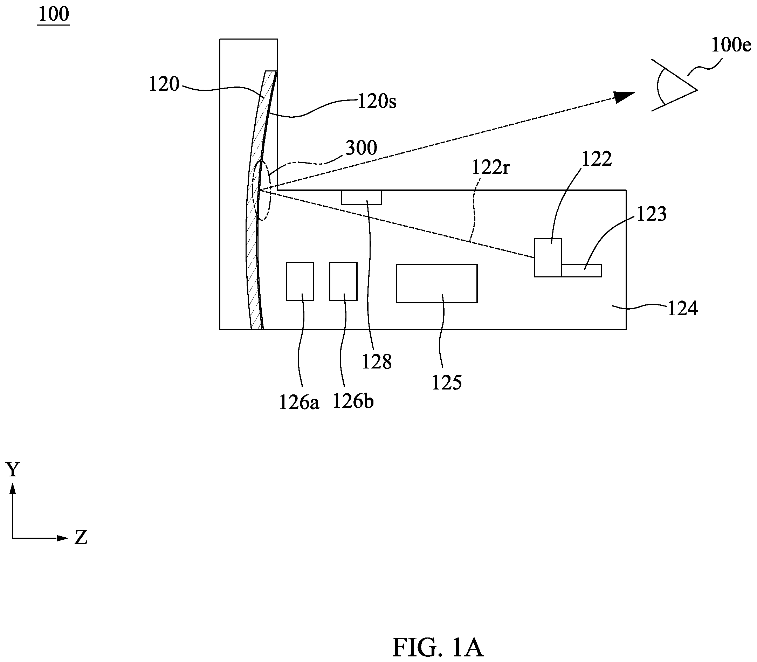

FIG. 1A shows an optical sighting device according to certain implementations of the disclosure.

The optical sighting device 100 comprises a transmissive screen 120 and a display device 122. The transmissive screen 120 and the display device 122 are disposed at a base 124. The transmissive screen 120 is disposed at a first end of the optical sighting device 100, and the display device 122 is disposed at a second end of the optical sighting device 100. The display device 122 faces a concave surface 120s of the transmissive screen 120. Light 122r emitted from the display device 122 can be projected onto the concave surface 120s of the transmissive screen 120. Eyes 100e of an user (also referred to as an observer) can observe content (e.g., a pattern or information 300) projected by the display device 122 onto the transmissive screen 120.

The optical sighting device 100 further comprises a control system 125, buttons 126a and 126b, and an environment sensor 128. The user can change the content projected by the display device 122 through the buttons 126a and 126b. In certain embodiments, when the user presses the button 126a or 126b, the pattern or information 300 projected by the display device 122 onto the transmissive screen 120 will change.

In certain embodiments, when the user presses the button 126a or 126b, the pattern or information 300 projected by the display device 122 onto the transmissive screen 120 will undergo a change in shape or size. In certain embodiments, the control system 125 can change the content projected by the display device 122 in response to a signal provided by the environment sensor 128. In certain embodiments, the control system 125 can change brightness of the display device 122 in response to the signal provided by the environment sensor 128. Therefore, brightness of the pattern or information 300 projected by the display device 122 onto the transmissive screen 120 can be changed in response to the signal provided by the environment sensor 128. In certain embodiments, the control system 125 can change contrast of the display device 122 in response to the signal provided by the environment sensor 128. Therefore, contrast of the pattern or information 300 projected by the display device 122 onto the transmissive screen 120 can be changed in response to the signal provided by the environment sensor 128.

In certain embodiments, the display device 122 includes a passive micro display light emitting assembly. In certain embodiments, the display device 122 includes an active micro display light emitting assembly. In certain embodiments, the display device 122 may use at least one of the following display technologies: light emitting diode (LED), organic light emitting diode (OLED), liquid crystal on silicon (LCOS), liquid crystal display (LCD), digital micromirror device (DMD), digital light processing (DLP), organic light emitting diode on silicon (OLEDOS), or micro light emitting diode (Micro LED).

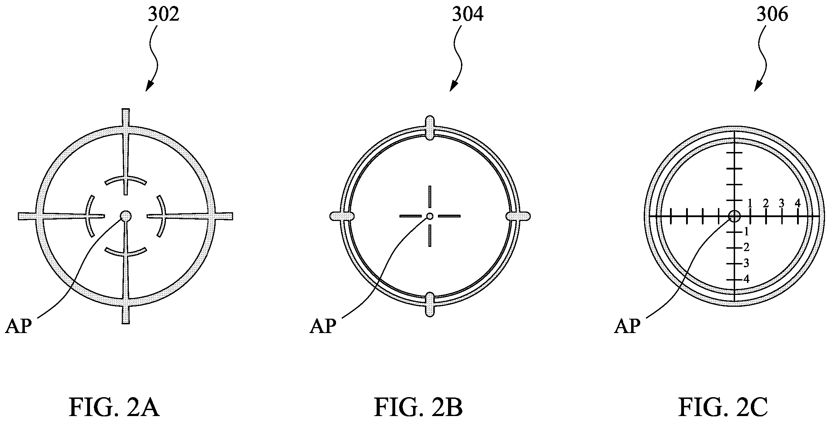

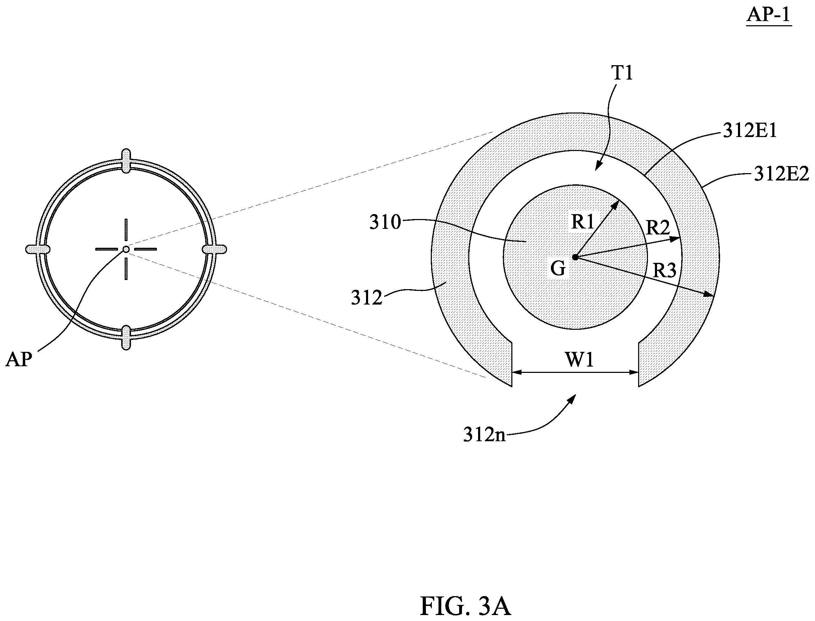

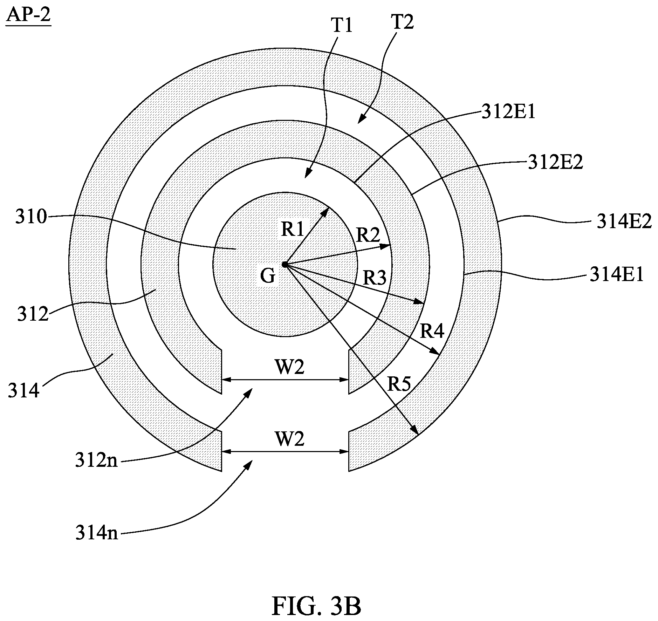

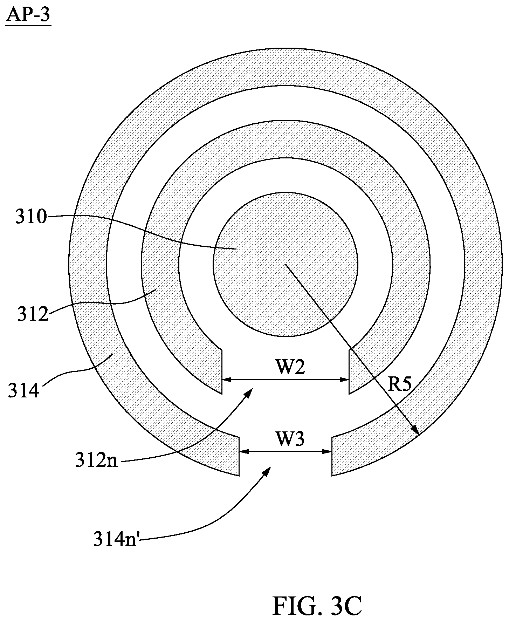

The display device 122 may be controlled by the control system 125 to project a pattern on the transmissive screen 120 (e.g., reticle patterns 302, 304, and 306 shown in FIGS. 2A, 2B, and 2C, together with central aiming points AP-1, AP-2, and AP-3 illustrated in FIGS. 3A, 3B, and 3C). The display device 122 can project different patterns on the transmissive screen 120 by activating (or illuminating) different parts of the electrodes. Details of the projected patterns will be discussed in following paragraphs.

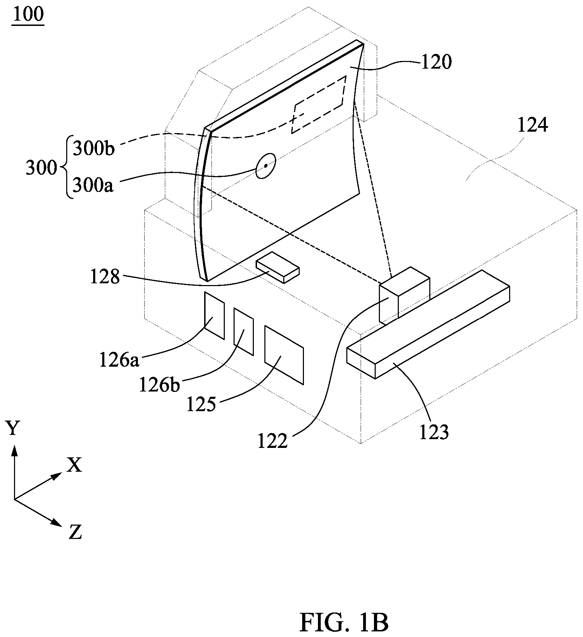

FIG. 1B shows a perspective view of the optical sighting device according to certain implementations of the disclosure. As shown in FIG. 1B, the display device 122 can be disposed in the base 124 via a holding structure 123. In certain embodiments, the holding structure 123 is designed to be adjustable for adjusting the position of the pattern or information 300 on the transmissive screen 120. For example, the user can adjust the holding structure 123 to move the pattern or information 300 along a X-axis direction on the transmissive screen 120. Similarly, the user can adjust the holding structure 123 to move the pattern or information 300 along a Y-axis direction or a Z-axis direction on the transmissive screen 120. In certain embodiments, clarity of the pattern or information 300 on the transmissive screen 120 can be adjusted by adjusting the holding structure 123.

As shown in FIG. 1B, the pattern or information 300 may comprise a pattern portion 300a and an information portion 300b. The pattern portion 300a may comprise patterns of different shapes or colors, including but not limited to the reticle patterns illustrated in FIGS. 2A, 2B, and 2C. The reticle patterns illustrated in FIGS. 2A, 2B, and 2C may include, for example, the central aiming point patterns illustrated in FIGS. 3A, 3B, and 3C. The information portion 300b may comprise various types of information for the user's reference when aiming, such as but not limited to at least one of wind speed, ballistic deflection, or humidity.

FIGS. 2A, 2B, and 2C show pattern portions 300a that may be shown on the transmissive screen 120 according to certain implementations of the disclosure. FIG. 2A shows a reticle pattern 302. In certain embodiments, the whole reticle pattern 302 may be in the same color. In certain embodiments, the reticle pattern 302 may include different colors. The reticle pattern 302 includes a central aiming point AP. In the present application, the central aiming point AP has a variable size, which will be discussed in detail in following paragraphs. FIG. 2B shows a reticle pattern 304. In certain embodiments, the whole reticle pattern 304 may be in the same color. In certain embodiments, the reticle pattern 304 may include different colors. The reticle pattern 304 includes a central aiming point AP. In the present application, the central aiming point AP has a variable size, which will be discussed in detail in following paragraphs. FIG. 2C shows a reticle pattern 306. In certain embodiments, the whole reticle pattern 306 may be in the same color. In certain embodiments, the reticle pattern 306 may include different colors. The reticle pattern 306 includes a central aiming point AP. In the present application, the central aiming point AP has a variable size, which will be discussed in detail in following paragraphs.

FIGS. 3A, 3B, and 3C show central aiming points AP of reticle patterns according to certain implementations of the disclosure. FIG. 3A illustrates a central aiming point AP-1. The central aiming point AP-1 is a pattern projected onto the transmissive screen 120 by the display device 122. The central aiming point AP-1 can be an aiming point close to a geometric center of the reticle pattern 302, 304, or 306 illustrated in FIGS. 2A, 2B, or 2C. The central aiming point AP-1 includes a first pattern 310 and a second pattern 312. The first pattern 310 has a geometric center G. The first pattern 310 may be a solid circle having a radius R1. In other embodiments, the first pattern 310 may be a solid geometric shape such as a triangle, a rectangle, a diamond, a V-shape, or an inverted V-shape.

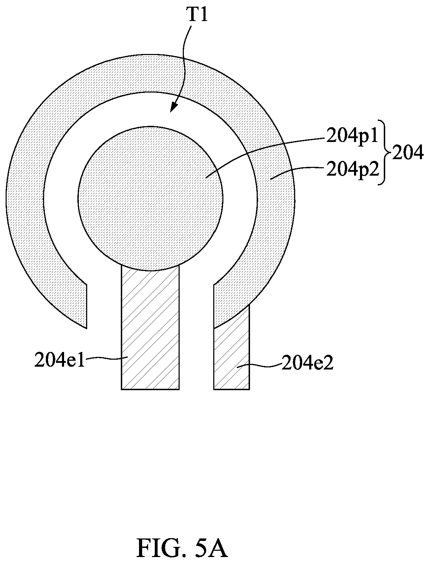

The second pattern 312 surrounds the first pattern 310 radially outward from the geometric center G. The second pattern 312 has an inner periphery 312E1 proximate to the first pattern 310 and an outer periphery 312E2 distal from the first pattern 310. The inner periphery 312E1 of the second pattern 312 maintains equal spacing R2 from the geometric center G, and the outer periphery 312E2 of the second pattern 312 maintains equal spacing R3 from the geometric center G. The inner periphery 312E1 of the second pattern 312 maintains equal spacing (R2-R1) from the first pattern 310. In other embodiments, the inner periphery 312E1 of the second pattern 312 may also have unequal spacing from the first pattern 310 through a modification. The second pattern 312 has an opening 312n with a width W1. The cause of the opening 312n will be described in following paragraphs with reference to FIG. 5A.

Referring to FIG. 3A, the second pattern 312 is spaced apart from the first pattern 310 by an annular gap T1. The width of the annular gap T1 is given by the difference between R2 and R1. In certain embodiments, the radius R1 of the first pattern 310 may be in a range from 10 micrometers (µm) to 14 µm. In certain embodiments, the difference between R2 and R1 (i.e., the width of the annular gap T1) may be in a range from 2 µm to 8 µm. It should be noted that the width of the annular gap T1 must be controlled within a certain range, so that when the first pattern 310 and the second pattern 312 appear together, the user's eyes can ignore the dark annular gap T1, and thus the central aiming point AP-1 on the transmissive screen 120 observed by the user will be very similar to a solid circle with a radius R3. Specifically, the user can control the shape of the central aiming point AP-1 through the button 126a or 126b. When the user controls to make the first pattern 310 appear alone, the user sees the central aiming point AP-1 on the transmissive screen 120 as a circle with a radius R1. When the user controls to make the first pattern 310 and the second pattern 312 appear together, the user sees the central aiming point AP-1 on the transmissive screen 120 similar to a circle with a radius R3. With the above design, the user can change the size of the central aiming point of the optical sighting device 100 through the button 126a or 126b according to different application scenarios, without the need to purchase various target sighting devices with different aiming point sizes, improving convenience of use and reducing unnecessary expenses.

FIG. 3B illustrates a central aiming point AP-2. The central aiming point AP-2 is a pattern projected onto the transmissive screen 120 by the display device 122. The central aiming point AP-2 can be an aiming point close to a geometric center of the reticle pattern 302, 304, or 306 illustrated in FIGS. 2A, 2B, or 2C. As shown in FIG. 3B, the central aiming point AP-2 includes a first pattern 310, a second pattern 312, and a third pattern 314. The first pattern 310 has a geometric center G. The first pattern 310 may be a solid circle having a radius R1. The second pattern 312 surrounds the first pattern 310 radially outward from the geometric center G. The third pattern 314 surrounds the second pattern 312 radially outward from the geometric center G.

The second pattern 312 has an inner periphery 312E1 proximate to the first pattern 310 and an outer periphery 312E2 distal from the first pattern 310. The inner periphery 312E1 of the second pattern 312 maintains equal spacing R2 from the geometric center G, and the outer periphery 312E2 of the second pattern 312 maintains equal spacing R3 from the geometric center G. The second pattern 312 has an opening 312n with a width W2.

The third pattern 314 has an inner periphery 314E1 proximate to the second pattern 312 and an outer periphery 314E2 distal from the second pattern 312. The inner periphery 314E1 of the third pattern 314 maintains equal spacing R4 from the geometric center G, and the outer periphery 314E2 of the third pattern 314 maintains equal spacing R5 from the geometric center G. The third pattern 314 has an opening 314n with a width W2. The inner periphery 314E1 of the third pattern 314 maintains equal spacing (R4-R3) from the second pattern 312.

Referring to FIG. 3B, the second pattern 312 is spaced apart from the first pattern 310 by an annular gap T1. The third pattern 314 is spaced apart from the second pattern 312 by an annular gap T2. The annular gap T1 has the same features as the annular gap T1 in FIG. 3A and will not be repeated herein.

The width of the annular gap T2 is given by the difference between R4 and R3. In certain embodiments, R3 may be in a range from 22 µm to 28 µm. In certain embodiments, the difference between R4 and R3 (i.e., the width of the annular gap T2) may be in a range from 2 µm to 8 µm. It should be noted that the width of the annular gap T1 must be controlled within a certain range, so that when the first pattern 310, the second pattern 312, and the third pattern 314 appear together, the central aiming point AP-2 on the transmissive screen 120 observed by the user will be very similar to a solid circle with a radius R5. Specifically, the user can control the shape of the central aiming point AP-2 through the button 126a or 126b. When the user controls to make the first pattern 310 appear alone, the user sees the central aiming point AP-2 on the transmissive screen 120 as a circle with a radius R1. When the user controls to make the first pattern 310 and the second pattern 312 appear together, the user sees the central aiming point AP-2 on the transmissive screen 120 similar to a circle with a radius R3. When the user controls to make the first pattern 310, the second pattern 312, and the third pattern 314 appear together, the user sees the central aiming point AP-2 on the transmissive screen 120 similar to a circle with a radius R5.

FIG. 3C illustrates a central aiming point AP-3. The central aiming point AP-3 is a pattern projected onto the transmissive screen 120 by the display device 122. The central aiming point AP-3 can be an aiming point close to a geometric center of the reticle pattern 302, 304, or 306 illustrated in FIGS. 2A, 2B, or 2C. As shown in FIG. 3C, the central aiming point AP-3 includes a first pattern 310, a second pattern 312, and a third pattern 314'. The central aiming point AP-3 in FIG. 3C has a similar structure to the central aiming point AP-2 in FIG. 3B, with the only difference being that a width W3 of the opening 314n' of the third pattern 314' is different from the width W2 of the opening 312n of the second pattern 312. In certain embodiments, the width W3 of the opening 314n' is smaller than the width W2 of the opening 312n. Because the opening 314n' has a smaller width W3, when the first pattern 310, the second pattern 312, and the third pattern 314' appear together, the dark opening 314n' will be less noticeable, and the user can see a central aiming point AP-3 with a radius R5 on the transmissive screen 120.

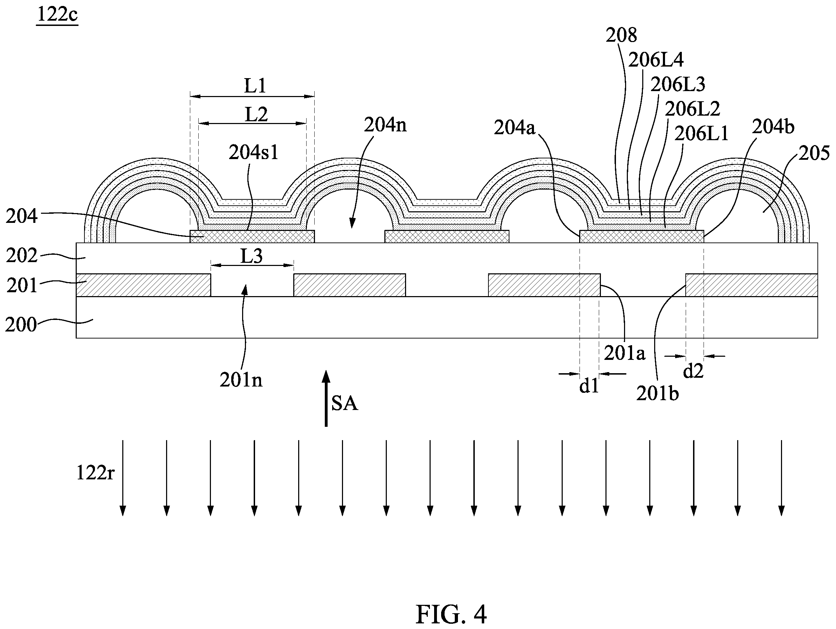

FIG. 4 shows a cross-sectional structure 122c of a display device 122 according to certain implementations of the disclosure. In FIG. 4, the display device 122 may be a backlit display device, and light 122r emitted by the display device 122 is emitted downward in FIG. 4, projected onto the transmissive screen 120 (not shown). The cross-sectional structure 122c comprises a substrate 200, a light shielding layer 201, a covering layer 202, a first conductive layer 204, a protrusion 205, a carrier injection layer 206L1, a carrier transport layer 206L2, an organic emission layer 206L3, an organic carrier transport layer 206L4, and a second conductive layer 208. In the disclosure, the carrier injection layer 206L1, the carrier transport layer 206L2, the organic emission layer 206L3, and the organic carrier transport layer 206L4 may be collectively referred to as an organic emitting layer.

In some embodiments, the substrate 200 may comprise a thin film transistor (TFT) array. In some embodiments, the substrate 200 comprises a base material (not shown), a dielectric layer (not shown), and one or more circuits (not shown) disposed on or in the base material. In some embodiments, the base material is a transparent base material, or at least a portion thereof is transparent. In some embodiments, the base material is a non-flexible base material, and a material of the base material may comprise glass, quartz, low temperature polysilicon (LTPS), or any other suitable material. In some embodiments, the base material is a flexible base material, and a material of the base material may comprise transparent epoxy resin, polyimide, polyvinyl chloride, polymethyl methacrylate, or any other suitable material. The dielectric layer may be disposed on the base material as needed. In some embodiments, the dielectric layer may comprise silicon oxide, silicon nitride, silicon oxynitride, or any other suitable material.

In some embodiments, the circuit(s) may comprise a complementary metal-oxide-semiconductor (CMOS) circuit, or may include several transistors and several capacitors near the transistors, wherein the transistors and the capacitors are formed on the dielectric layer. In some embodiments, the transistors are thin-film transistors (TFTs). Each transistor comprises source/drain regions (including at least a source region and a drain region), a channel region between the source/drain regions, a gate electrode disposed above the channel region, and a gate insulator between the channel region and the gate electrode. The channel region of the transistor may be formed of a semiconductor material, such as silicon or any other element selected from Group IV or Groups III and V.

The light shielding layer 201 is formed on the substrate 200. The light shielding layer 201 may be a discontinuous structure with several apertures 201n. The light shielding layer 201 can absorb more than 90% of visible light. In some embodiments, the light shielding layer 201 may include a blackbody material. In some embodiments, the light shielding layer 201 comprises a single material layer. In some embodiments, the light shielding layer 201 comprises a composite layer formed of multiple materials. In some embodiments, the light shielding layer 201 comprises an organic material. In some embodiments, the light shielding layer 201 comprises an inorganic material.

The covering layer 202 is formed above the substrate 200, and covers the light shielding layer 201 from above. The covering layer 202 is formed in the apertures 201n of the light shielding layer 201. The covering layer 202 covers a top surface and two side surfaces of the light shielding layer 201. As shown on the right side of FIG. 4, an aperture 201n of the light shielding layer 201 can have sidewalls201a and 201b.

The first conductive layer 204 is formed above the covering layer 202. The first conductive layer 204 may have several apertures 204n in a cross-sectional view according to the shown pattern. The first conductive layer 204 contacts the covering layer 202. The first conductive layer 204 is electrically connected to the one or more circuits (not shown) in the substrate 200.

A plurality of protrusions 205 are formed in the apertures 204n of the first conductive layer 204. A peripheral region of the first conductive layer 204 is covered by the protrusions 205. In some embodiments, edge corners of the first conductive layer 204 are surrounded by the protrusions 205. In some embodiments, sidewalls 204a and 204b of the first conductive layer 204 contact the protrusions 205 and are covered by the protrusions 205. The covering layer 102 electrically insulates the light shielding layer 201 from the first conductive layer 204. In the present application, the first conductive layer 204 may be an anode.

The first conductive layer 204 may have a total thickness from about 1500 Å to about 2700 Å. In some embodiments, the first conductive layer 204 may have a total thickness from about 1800 Å to about 2200 Å. In some embodiments, the first conductive layer 204 may have a total thickness of about 2200 Å. The first conductive layer 204 may include ITO, IZO, IGZO, AlCu alloy, AgMo alloy, ITO (or IZO or IGZO) from about 50 Å to 500 Å and a metal film (Ag, Al, Mg, or Au) from 500 Å to 2000 Å, or ITO (or IZO or IGZO) from about 50 Å to 1000 Å.

The carrier injection layer 206L1 is disposed on the covering layer 202, the protrusions 205, and an exposed surface 204s1 of the first conductive layer 204. The carrier injection layer 206L1 continuously covers the protrusions 205 and the exposed surface 204s1 of the first conductive layer 204. In some embodiments, the exposed surface 204s1 of the first conductive layer 204 is configured as an effective light emitting area of the display device 122. In the disclosure, the exposed surface 204s1 of the first conductive layer 204 refers to a portion of the top surface of the first conductive layer 204 that is not covered by the protrusions 205, and the portion has a length L2.

Optionally, the carrier injection layer 206L1 contacts the protrusions 205. In some embodiments, the carrier injection layer 206L1 contacts the first conductive layer 204. In some embodiments, the carrier injection layer 206L1 is an organic material. In some embodiments, the carrier injection layer 206L1 is configured to perform hole injection. In some embodiments, the carrier injection layer 206L1 is a hole injection layer. In some embodiments, the carrier injection layer 206L1 may have a thickness from about 80 Å to about 500 Å.

The carrier transport layer 206L2 is disposed on the covering layer 202, the protrusions 205, and the exposed surface 204s1 of the first conductive layer 204. The carrier transport layer 206L2 is disposed above the carrier injection layer 206L1 and completely covers the carrier injection layer 206L1. The carrier injection layer 206L1 is disposed under the carrier transport layer 206L2. The carrier transport layer 206L2 continuously covers the carrier injection layer 206L1. The carrier transport layer 206L2 covers the plurality of protrusions 205 and the first conductive layer 204. Optionally, the carrier transport layer 206L2 contacts the carrier injection layer 206L1. In some embodiments, the carrier transport layer 206L2 is an organic material. In some embodiments, the carrier transport layer 206L2 is configured to perform hole transport. In some embodiments, the carrier transport layer 206L2 is a first hole transport layer. In some embodiments, the carrier transport layer 206L2 may have a thickness from about 80 Å to about 500 Å.

The organic emission layer 206L3 is disposed on the covering layer 202, the protrusions 205, and the exposed surface 204s1 of the first conductive layer 204. The organic emission layer 206L3 is disposed above the carrier transport layer 206L2 and completely covers the carrier transport layer 206L2. The carrier transport layer 206L2 is disposed under the organic emission layer 206L3. The organic emission layer 206L3 continuously covers the carrier transport layer 206L2. The organic emission layer 206L3 covers the plurality of protrusions 205 and the first conductive layer 204. Optionally, the organic emission layer 206L3 contacts the carrier transport layer 206L2. The organic emission layer 206L3 is configured to emit a first color.

The organic carrier transport layer 206L4 is disposed on the covering layer 202, the protrusions 205, and the exposed surface 204s1 of the first conductive layer 204. The organic carrier transport layer 206L4 is disposed above the organic emission layer 206L3 and completely covers the organic emission layer 206L3. The organic emission layer 206L3 is disposed under the organic carrier transport layer 206L4. The organic carrier transport layer 206L4 continuously covers the organic emission layer 206L3. The organic carrier transport layer 206L4 covers the plurality of protrusions 205 and the first conductive layer 204. Optionally, the organic carrier transport layer 206L4 contacts the organic emission layer 206L3.

The second conductive layer 208 is disposed on the covering layer 202, the protrusions 205, and an exposed surface 204s1 of the first conductive layer 204. The second conductive layer 208 is disposed above the organic carrier transport layer 206L4 and completely covers the organic carrier transport layer 206L4. In some cases, the second conductive layer 208 is patterned to cover only the effective light emitting area of the display device 122. In some cases, the second conductive layer 208 contacts the organic carrier transport layer 206L4.

The second conductive layer 208 may have a total thickness from about 80 Å to about 500 Å. In some embodiments, the second conductive layer 208 may have a total thickness from about 80 Å to about 150 Å. In some embodiments, the second conductive layer 208 may have a total thickness from about 150 Å to about 200 Å. In some embodiments, the second conductive layer 208 may have a total thickness from about 200 Å to about 300 Å. In some embodiments, the second conductive layer 208 may have a total thickness from about 300 Å to about 400 Å. In some embodiments, the second conductive layer 208 may have a total thickness from about 400 Å to about 500 Å.

In the present application, the second conductive layer 208 may be a cathode. The second conductive layer 208 may be a metal material, such as Ag, Mg, or the like. In some embodiments, the second conductive layer 208 comprises indium tin oxide (ITO) or indium zinc oxide (IZO).

Referring to FIG. 4 , the first conductive layer 204 may have a first sidewall 204a and a second sidewall 204b. The light shielding layer 201 may have a first sidewall 201a and a second sidewall 201b. The first sidewall 204a of the first conductive layer 204 is not aligned with the first sidewall 201a of the light shielding layer 201. In certain embodiments, a displacement d1 exists between the first sidewall 204a of the first conductive layer 204 and the first sidewall 201a of the light shielding layer 201.

The second sidewall 204b of the first conductive layer 204 is not aligned with the second sidewall 201b of the light shielding layer 201. In certain embodiments, a displacement d2 exists between the second sidewall 204b of the first conductive layer 204 and the second sidewall 201b of the light shielding layer 201. In certain embodiments, the displacement d2 may be substantially equal to the displacement d1. In certain embodiments, the displacement d1 and the displacement d2 may vary slightly due to the manufacturing process.

The displacement d1 and the displacement d2 between the light shielding layer 201 and the first conductive layer 204 can allow the light shielding layer 201 to effectively block stray light emitted from near the first sidewall 201a and the second sidewall 201b, enhancing sharpness of the displayed patterns of the display device 122.

As shown in FIG. 4, the first conductive layer 204 is divided into several parts by the apertures 204n, and a single part may have a length L1. A spacing length between two adjacent protrusions 205 is L2 (i.e., a width of the exposed surface 204s1 of the first conductive layer 204). The light shielding layer 201 is divided into several parts by the apertures 201n, and an apertures 201n may have a length L3. The length L1, the length L2, and the length L3 have a relationship L1>L2>L3. The spacing length between two adjacent protrusions 205 is L2, which may correspond to the effective light emitting area of the display device 122. To be specific, between the first conductive layer 204 and the second conductive layer 208, the carrier injection layer 206L1, the carrier transport layer 206L2, the organic emission layer 206L3, and the organic carrier transport layer 206L4 arranged within the length L2 range can emit light as a result of carrier transport.

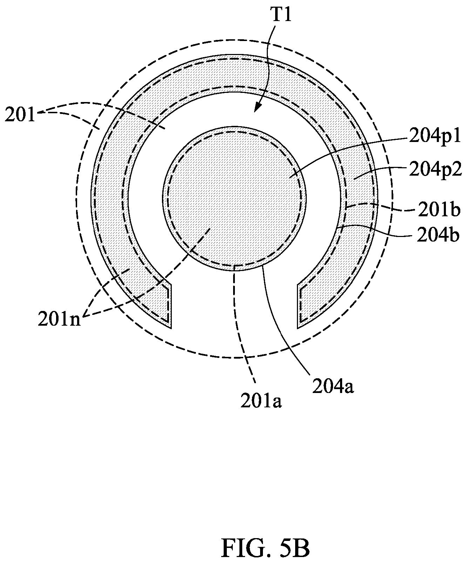

The length L3 of the apertures 201n is smaller than the effective light emitting area (i.e., the length L2), allowing the light shielding layer 201 to control a bright pattern of the display device 122. Specifically, in the cross-sectional view illustrated in FIG. 4, the display device 122 has an effective light emitting area with the length L2, but only the light passing through the apertures 201n (i.e., the length L3) of the light shielding layer 201 can be seen by the user. A bright pattern projected onto the transmission screen 120 by the display device 122 corresponds to the pattern formed by the apertures 201n. A relationship between the light shielding layer 201 and the first conductive layer 204 will be described in following paragraphs with reference to FIG. 5B based on a top-down perspective SA.

FIG. 5A shows a first conductive layer according to certain implementations of the disclosure. FIG. 5A shows a top view of the first conductive layer 204. The first conductive layer 204 includes a first portion 204p1 and a second portion 204p2. An annular gap T1 exists between the first portion 204p1 and the second portion 204p2. The annular gap T1 may correspond to the apertures 204n, i.e., discontinuous portion of the first conductive layer 204, illustrated in FIG. 4. The first conductive layer 204 further includes a third portion 204e1 and a fourth portion 204e2. The third portion 204e1 is electrically connected to the first portion 204p1 and extends through the opening of the second portion 204p2, and the fourth portion 204e2 is electrically connected to the second portion 204p2. The third portion 204e1 does not contact the second portion 204p2.

While not shown in FIG. 5A,the carrier injection layer 206L1, the carrier transport layer 206L2, the organic emission layer 206L3, and the organic carrier transport layer 206L4 may be disposed on the first portion 204p1 and the second portion 204p2 of the first conductive layer 204, so that light can be emitted in the first portion 204p1 and the second portion 204p2, and a pattern corresponding to shapes of the first portion 204p1 and the second portion 204p2 is projected onto the transmissive screen 120. In contrast, no light is emitted in the third portion 204e1 and the fourth portion 204e2, and they are used only for electrical conduction. The light emitted from the first portion 204p1 and the second portion 204p2 of the first conductive layer 204 can therefore be projected onto the transmissive screen 120 forming the corresponding first pattern 310 and second pattern 312 as shown in FIG.3A. Therefore, the first conductive layer 204 has the first portion 204p1 corresponding to the first pattern 310 and the second portion 204p2 corresponding to the second pattern 312.

Referring to both FIG. 3A and FIG. 5A, no light is emitted in the third portion 204e1 of the first conductive layer 204, but the third portion 204e1 can conduct electricity to the first portion 204p1 such that the light can be emitted in the first portion 204p1. The second portion 204p2 has an opening, such that the third portion 204e1 can pass therethrough and connect to the first portion 204p1. Therefore, when the second portion 204p2 in FIG. 5A is projected onto the transmissive screen 120, the opening 312n of the second pattern 312 in FIG. 3A is formed.

FIG. 5B shows a relationship between the first conductive layer and a light shielding layer in a top view according to certain implementations of the disclosure. The first conductive layer and the light shielding layer shown in FIG5B are illustrated based on the top-down perspective SA in FIG. 4. For ease of illustration, only the first portion 204p1 and the second portion 204p2 of the first conductive layer are shown in FIG. 5, and the third portion 204e1 and the fourth portion 204e2 are omitted. As shown in FIG. 5B, the light shielding layer 201 has the apertures 201n, and the shapes of the apertures 201n substantially correspond to the first portion 204p1 and the second portion 204p2 of the first conductive layer. However, it should be noted that the first sidewall 204a of the first conductive layer 204 is not aligned with the first sidewall 201a of the light shielding layer 201, and the second sidewall 204b of the first conductive layer 204 is not aligned with the second sidewall 201b of the light shielding layer 201. In addition, viewed from the top-down perspective SA, the light shielding layer 201 covers the annular gap T1 between the first portion 204p1 and the second portion 204p2 of the first conductive layer.

In addition, viewed from the top-down perspective SA, the light shielding layer 201 partially overlaps the first portion 204p1 of the first conductive layer 204, and the light shielding layer 201 partially overlaps the second portion 204p2 of the first conductive layer 204. As discussed above, the displacements between the light shielding layer 201 and the first conductive layer 204 can allow the light shielding layer 201 to effectively block stray light emitted from near the first sidewall 201a and the second sidewall 201b, enhancing the sharpness of the displayed patterns of the display device 122.

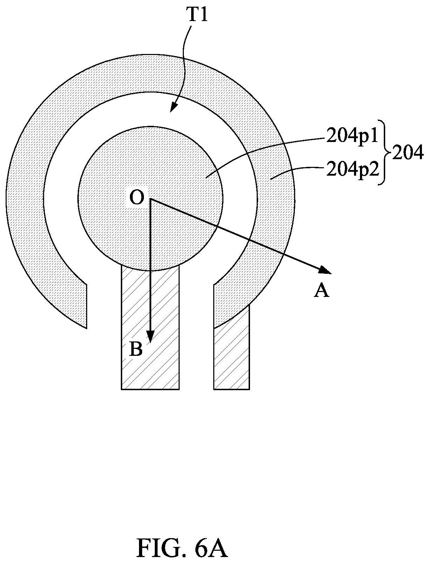

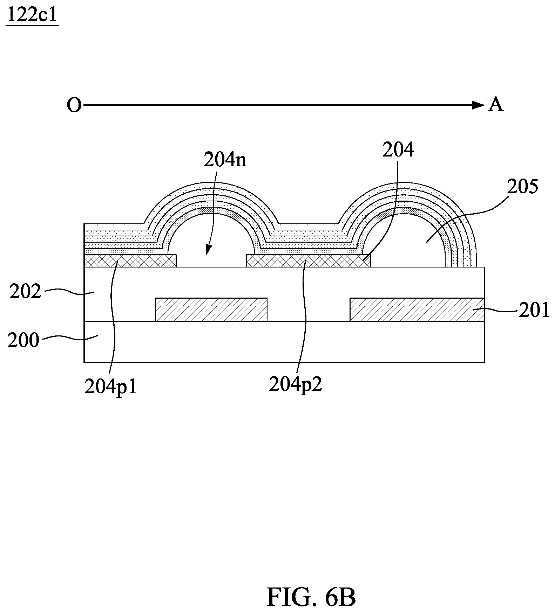

FIG. 6A shows a first conductive layer according to certain implementations of the disclosure. The first conductive layer illustrated in FIG. 6A is the same as the first conductive layer illustrated in FIG. 5A. The cross sections along line OA and line OB will be described in following paragraphs with reference to FIGS. 6B-6D.

While the first conductive layer 204 corresponding to FIG. 3B or 3C is not explicitly illustrated in the disclosure, one skilled in the art should understand that the first conductive layer 204 corresponding to FIG. 3B or 3C would have three portions, corresponding to the first pattern 310, the second pattern 312, and the third pattern 314, respectively. The portions of the first conductive layer 204 corresponding to the second pattern 312 and the third pattern 314 will each have an opening.

FIG. 6B shows a cross-sectional structure of the display device according to certain implementations of the disclosure along line OA shown in FIG. 6A. FIG. 6B shows a cross-sectional structure 122c1 along line OA shown in FIG. 6A. The light shielding layer 201, the covering layer 202, the first conductive layer 204, the protrusions 205, the carrier injection layer 206L1, the carrier transport layer 206L2, the organic emission layer 206L3, the organic carrier transport layer 206L4, and the second conductive layer 208 are sequentially disposed on the substrate 200. The aperture 204n between the first portion 204p1 and the second portion 204p2 of the first conductive layer 204 corresponds to the annular gap T1 shown in FIG. 6A.

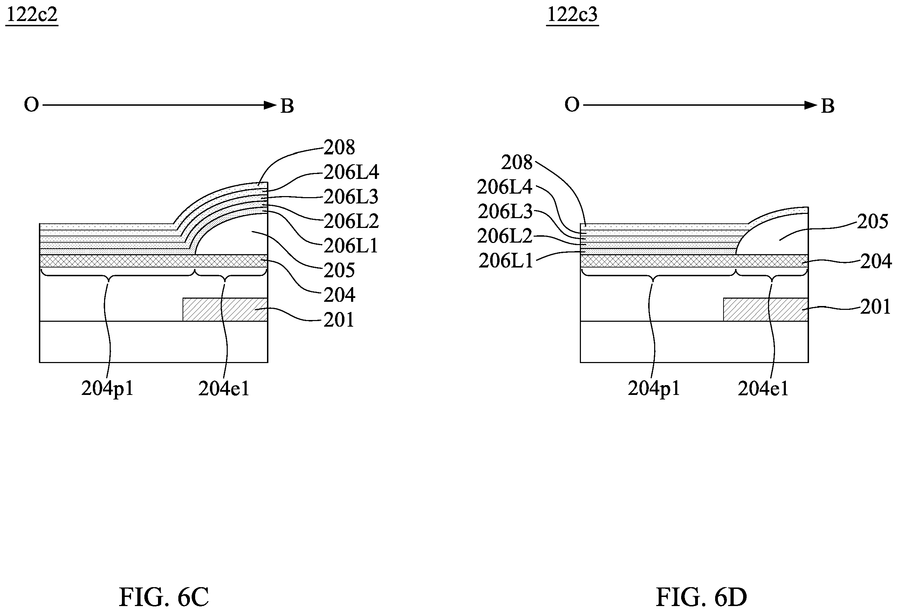

FIG. 6C shows a cross-sectional structure of the display device according to certain implementations of the disclosure along line OB shown in FIG. 6A. FIG. 6C shows a cross-sectional structure 122c2 along line OB shown in FIG. 6A.

The light shielding layer 201, the covering layer 202, the first conductive layer 204, the protrusions 205, the carrier injection layer 206L1, the carrier transport layer 206L2, the organic emission layer 206L3, the organic carrier transport layer 206L4, and the second conductive layer 208 are sequentially disposed on the substrate 200. The first conductive layer 204 includes the first portion 204p1 and the third portion 204e1. As shown in FIG. 6C, the carrier injection layer 206L1, the carrier transport layer 206L2, the organic emission layer 206L3, the organic carrier transport layer 206L4, and the second conductive layer 208 are disposed above the first portion 204p1 of the first conductive layer 204, and thus the first portion 204p1 of the first conductive layer 204 corresponds to a portion in which the light is emitted. The protrusions 205 covering above the third portion 204e1 of the first conductive layer 204 isolate the first conductive layer 204 from the carrier injection layer 206L1, the carrier transport layer 206L2, the organic emission layer 206L3, the organic carrier transport layer 206L4, and the second conductive layer 208 above the first conductive layer 204, and thus the third portion 204e1 of the first conductive layer 204 corresponds to a portion in which no light is emitted. The third portion 204e1 of the first conductive layer 204 is used only for electrical conduction. In certain embodiments, the light shielding layer 201 also covers the third portion 204e1 of the first conductive layer 204, so that stray light emitted from an area where it connects with the first portion 204p1 is not visible to the user, enhancing sharpness of the displayed patterns of the display device 122.

FIG. 6D shows a cross-sectional structure of the display device according to certain implementations of the disclosure along line OB shown in FIG. 6A. FIG. 6D shows a cross-sectional structure 122c3 along line OB shown in FIG. 6A. The cross-sectional structure 122c3 illustrated in FIG. 6D is similar to the cross-sectional structure 122c2 illustrated in FIG. 6C, with the only difference being that the carrier injection layer 206L1, the carrier transport layer 206L2, the organic emission layer 206L3, and the organic carrier transport layer 206L4 are disposed only above the first portion 204p1 of the first conductive layer 204, but do not cover the third portion 204e1 of the first conductive layer 204 as shown in FIG. 6C. The first portion 204p1 of the first conductive layer 204 corresponds to a portion in which the light is emitted, and the third portion 204e1 of the first conductive layer 204 corresponds to a portion in which no light is emitted.

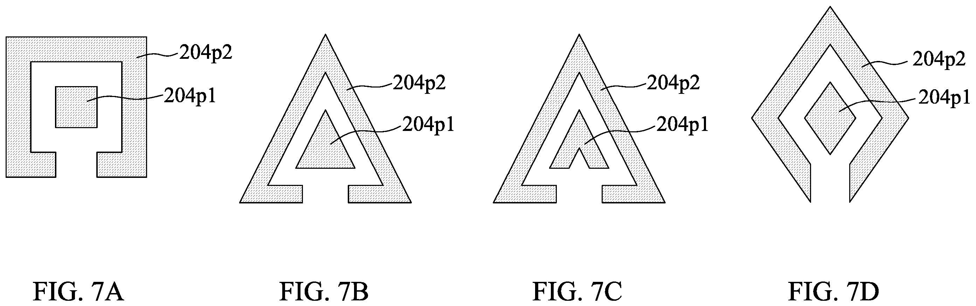

FIGS. 7A, 7B, 7C, and 7D show first conductive layers according to certain implementations of the disclosure.

FIG. 7A shows a top view of a first conductive layer 204. The first conductive layer 204 includes a first portion 204p1 and a second portion 204p2. In this embodiment, the first portion 204p1 has a rectangular shape, and the second portion 204p2 surrounds outside the first portion 204p1 and has an opening. When the first conductive layer 204 is electrically conducted, the display device 122 can display the first pattern 310 and the second pattern 312 having corresponding shapes on the transmissive screen 120.

FIG. 7B shows a top view of a first conductive layer 204. The first conductive layer 204 includes a first portion 204p1 and a second portion 204p2. In this embodiment, the first portion 204p1 has a triangular shape, and the second portion 204p2 surrounds outside the first portion 204p1 and has an opening. When the first conductive layer 204 is electrically conducted, the display device 122 can display the first pattern 310 and the second pattern 312 having corresponding shapes on the transmissive screen 120.

FIG. 7C shows a top view of a first conductive layer 204. The first conductive layer 204 includes a first portion 204p1 and a second portion 204p2. In this embodiment, the first portion 204p1 has an inverted V-shape, and the second portion 204p2 surrounds outside the first portion 204p1 and has an opening. When the first conductive layer 204 is electrically conducted, the display device 122 can display the first pattern 310 and the second pattern 312 having corresponding shapes on the transmissive screen 120.

FIG. 7D shows a top view of a first conductive layer 204. The first conductive layer 204 includes a first portion 204p1 and a second portion 204p2. In this embodiment, the first portion 204p1 has a diamond shape, and the second portion 204p2 surrounds outside the first portion 204p1 and has an opening. When the first conductive layer 204 is electrically conducted, the display device 122 can display the first pattern 310 and the second pattern 312 having corresponding shapes on the transmissive screen 120.

In all of FIGS. 7A, 7B, 7C, and 7D, the first portion 204p1 of the first conductive layer 204 has a solid geometric shape, and the second portion 204p2 surrounds outside the first portion 204p1 and has an opening.

The aforementioned content generally outlines the features of some implementations, allowing one skilled in the art to better understand various aspects of the disclosure. One skilled in the art should understand that hid disclosure can be easily used as a foundation to design or modify other processes and structures to achieve the same objectives and/or attain the same advantages as the embodiments described in the present application. One skilled in the art should also understand that such equivalent structures do not depart from the scope of the disclosed content, and various changes, substitutions, and modifications can be made without departing from the scope of the disclosure.

Furthermore, the scope of the present application is not limited to the specific embodiments of processes, machines, manufacture, compositions of matter, means, methods, or steps described in the specification. One skilled in the art will recognize, based on the teachings of the disclosure, that existing or future-developed processes, machines, manufacture, compositions of matter, means, methods, or steps having the same functions or achieving substantially the same results as those corresponding embodiments described herein can be used according to the disclosure. Accordingly, such processes, machines, manufacture, compositions of matter, means, methods, or steps are included within the scope of the claims of the present application.

## Claims

1. An optical sighting device (100), comprising:
a transmissive screen (120) disposed at a first end of the optical sighting device, the transmissive screen comprising a concave surface (120s); and
a display device (122) disposed at a second end of the optical sighting device, the display device configured to project a first pattern (310) alone or project the first pattern and a second pattern (312) together on the transmissive screen, wherein:
the first pattern and the second pattern have different shapes; and
the first pattern has a geometric center (G), and the second pattern surrounds the first pattern radially outward from the geometric center.

2. The optical sighting device according to claim **1,** wherein the display device comprises:
a substrate (200);
a light shielding layer (201) disposed on the substrate;
a covering layer (202) disposed above the substrate, the covering layer covering the light shielding layer;
a first conductive layer (204) disposed above the covering layer;
a plurality of organic emitting layers (206L1-206L4) disposed above the first conductive layer; and
a second conductive layer (208) disposed above the organic emitting layers.

3. The optical sighting device according to claim 2, wherein the first conductive layer has a first portion (204p1) corresponding to the first pattern and a second portion (204p2) corresponding to the second pattern.

4. The optical sighting device according to claim 3, wherein an annular gap (T1) exists between the second portion and the first portion of the first conductive layer, and in a top view, the light shielding layer (201) covers the annular gap.

5. The optical sighting device according to claim 4, wherein in the top view, the light shielding layer (201) partially overlaps the first portion (204p1) of the first conductive layer, and in the top view, the light shielding layer partially overlaps the second portion (204p2) of the first conductive layer.

6. The optical sighting device according to claim 1, further comprising a button (126a/126b) configured to control the display device to project the first pattern alone or project the first pattern and the second pattern together.

7. The optical sighting device according to claim 3, wherein the first portion of the first conductive layer has a solid geometric shape, and the second portion of the first conductive layer surrounds the first portion and has an opening (312n).

8. The optical sighting device according to claim 7, wherein the second pattern has an inner periphery proximate to the first pattern and an outer periphery distal from the first pattern, wherein the inner periphery of the second pattern maintains equal spacing or unequal spacing from the first pattern.

9. The optical sighting device according to claim 7, wherein the display device further comprises a protrusion (205) disposed on the first conductive layer, and wherein the first conductive layer further has a third portion (204e1) that is electrically connected to the first portion and extends through the opening of the second portion, and the protrusion is disposed on the third portion of the first conductive layer.

10. The optical sighting device according to claim 7, wherein the first conductive layer further has a third portion (204e1) that is electrically connected to the first portion and extends through the opening, the third portion does not contact the second portion, and the organic emitting layers cover the third portion.

11. The optical sighting device according to claim 3, wherein the display device is further configured to project a third pattern (314) on the transmissive screen, and the third pattern surrounds the second pattern radially outward from the geometric center.

12. The optical sighting device according to claim 11, wherein the third pattern has an inner periphery proximate to the second pattern and an outer periphery distal from the second pattern, wherein the inner periphery of the third pattern maintains equal spacing from the second pattern.

13. The optical sighting device according to claim 11, further comprising a button (126a/126b) configured to control the display device to project on the transmissive screen:
the first pattern alone;
the first pattern and the second pattern together; or
the first pattern, the second pattern, and the third pattern together.

14. The optical sighting device according to claim 4, wherein the annular gap has a width in a range from 2 µm to 8 µm.

15. The optical sighting device according to claim 11, wherein the first conductive layer has a third portion corresponding to the third pattern, and the third portion has an opening.
